# EUROPEAN PATENT APPLICATION

(11) **EP 4 726 440 A1**
(43) Date of publication of application: **15.04.2026**
(21) Application number: 24944113.0
(22) Date of filing: 31.07.2024
(51) Int. Cl.: G02B 1/10, H05K 7/20, G09F 9/30, C23C 14/30, C23C 14/08, C23C 14/10

(54) **DISPLAY FILM MATERIAL AND PREPARATION METHOD THEREFOR**

(30) Priority: 24.06.2024 CN 202410816422
(71) Applicant: Moguang New Energy Technology (Suzhou) Co., Ltd, Suzhou, Jiangsu 215151 (CN)
(72) Inventor: KONG, Dexing, Suzhou, Jiangsu 215151 (CN); ZONG, Linqi, Suzhou, Jiangsu 215151 (CN); LUO, Maohai, Suzhou, Jiangsu 215151 (CN); LYU, Bin, Suzhou, Jiangsu 215151 (CN)
(74) Representative: Murgitroyd & Company
(86) International application number: PCT/CN2024/108841
(87) International publication number: WO 2026/000535

(57) **Abstract**

The present disclosure relates to a display film material and a preparation method thereof. The display film material includes a substrate and an optical regulation layer disposed on the substrate, where the substrate is made of an optically transparent material, and the optical regulation layer is formed by alternate lamination of a low refractive index material and a high refractive index material. A refractive index difference between the low refractive index material and the high refractive index material is greater than 0.4. After light passes through the optical regulation layer and the substrate, the present disclosure finally achieves a visible light transmittance of over 90%, a maximum near-infrared blocking rate of over 80%, a high transmittance at 940-1000 nm, a mid-infrared emissivity of over 90%, and a cooling effect of 3-8 degrees Celsius.

## Description

### TECHNICAL FIELD

The present disclosure relates to a film, and in particular to a display film material and a preparation method thereof.

### BACKGROUND

With the global population growth and continuous social development, the problem of global warming is becoming increasingly serious, which in turn leads to a growing demand for refrigeration energy consumption. A traditional active refrigeration method is based on a compression-based cooling system. On one hand, a large amount of electricity is consumed and considerable carbon dioxide emissions are produced; and on the other hand, a refrigerant such as Freon used in the compression-based cooling system damages an ozone layer, thereby causing severe environmental issues. Distinct from traditional refrigeration methods, radiative cooling is a passive cooling method for emitting heat to the cold universe through thermal radiation. The Earth's atmosphere exhibits different transmittances for electromagnetic waves of different wavelengths, including an extremely high transmittance for electromagnetic waves in an 8-13 µm band, which is known as an "atmospheric window". Therefore, an excellent radiative cooling surface has an emissivity as high as possible in an 8-13 µm band and strongly reflects sunlight (0.3-2.5 µm), thereby achieving spontaneous cooling without consuming any energy. In summary, radiative cooling technology saves energy and alleviates greenhouse effects, environmental pollution, and other problems caused by traditional refrigeration.

With the development of nanophotonics and advanced manufacturing technologies, photonic crystals and metamaterials have been pioneeringly applied in radiative cooling materials. Nanophotonic crystals refer to nanophotonic materials with various layered structures and metasurface structures processed from semiconductor materials through coating processes such as magnetron sputtering and electron beam evaporation or micro-nano processing technologies, thereby achieving selective high emissivity in specific mid-infrared bands.

Radiation spectra of ordinary materials are usually very wide, while a photonic material may be used to design a heat source with a controllable, narrow-band emission spectrum, which is particularly needed in radiative cooling. Currently, many nanostructured materials have been applied in radiative cooling. However, most radiative cooling materials in the prior art are used in outdoor buildings such as walls and roofs, and rarely in display devices, because display devices have higher requirements for radiative cooling materials in terms of spectrum.

### SUMMARY

An objective of the present disclosure is to provide a radiative cooling film suitable for display devices, especially for display devices integrated with sensors, and based on this objective, the present disclosure provides a display film material, and through the design in material and structure, the film material achieves high visible light transmittance, high near-infrared reflectance, and high mid-infrared emissivity.

A technical solution adopted by the present disclosure is as follows: a display film material, including a substrate and an optical regulation layer disposed on the substrate, where the substrate has a visible light absorptance of < 5% (preferably no absorption) and a transmittance of > 90% in a 400-780 nm band, and a near-infrared light absorptance of < 5% (preferably no absorption) in a 900-1100 nm band; and the substrate may be made of an organic or inorganic material, or a flexible or rigid material, preferably one or more of Glass, PET, PC, PMMA, PE, COP, and other materials. The optical regulation layer is configured to regulate optical properties of the film material, make up for deficiencies of the substrate in optical properties, and enhance the operability of the material; and the optical regulation layer is formed by depositing a plurality of organic and/or inorganic materials, and after light passes through the optical regulation layer and the substrate, a transmittance in a visible light band of 400-780 nm is greater than 80% (preferably greater than 90%), an emissivity in a mid-infrared band of 8-13 µm is greater than 85% (preferably greater than 95%), a reflectance in a near-infrared band of 900-1400 nm is greater than 70%, and a transmittance in a 940-1100 nm band is > 70%.

More preferably, the substrate has an absorptance of less than 1% and a transmittance of greater than 90% in the 400-780 nm band, and an absorptance of less than 1% in the 900-1400 nm band, and the optical regulation layer is formed by alternate lamination of a low refractive index material and a high refractive index material, where a refractive index difference between the low refractive index material and the high refractive index material is greater than 0.5, and after the light passes through the optical regulation layer and the substrate, a transmittance in the 400-780 nm band is greater than 90%, an emissivity in the 8-13 µm band is greater than 85%, a reflectance in the 900-1400 nm band is greater than 80%, and a transmittance in the 940-1000 nm band is greater than 90%.

In the present disclosure, the optical regulation layer is formed by laminating at least two materials, a refractive index difference between the two materials is more than 0.4 (preferably more than 0.5, more preferably 0.5-0.8), and the material with a higher refractive index among the two materials is hereinafter referred to as the high refractive index material. The material with a lower refractive index is referred to as the low refractive index material, the high refractive index material and the low refractive index material are alternately laminated, and the alternate lamination of the high refractive index material and the low refractive index material enables to interfere with, selectively transmit or reflect light of different bands, thereby achieving spectral regulation. When the refractive index difference between the high refractive index material and the low refractive index material is more than 0.4, light in the 400-780 nm band and the 940-1100 nm band, through admittance matching interference of a multilayer film, has a refractive index 1 close to that of air, thereby achieving high transmittance in these bands; and the light has a value of ∞ far from the refractive index of air in the 900-1400 nm band ( excluding 940-1100 nm), thereby achieving high reflectance in this band.

The numbers of layers of the high refractive index material and the low refractive index material may be identical or different, the high refractive index material may include one or more materials, and similarly, the low refractive index material may include one or more materials; the present disclosure preferably has at least two layers of materials within a thickness range of 25 nm-500 nm, and a refractive index difference between the two layers of materials is 0.5-0.8, which is further explained in detail that when a film layer has a thickness less than a preferred thickness, the following problems occur during processing: (1) poor film uniformity, poor cooling effect, poor sensor sensitivity, and even failure of normal operation; (2) film layer stress imbalance, failure to form stress offset with an adjacent layer, and even film cracking; (3) amplification of error influence during normal processing, and failure to accurately control spectral deviations. When the film layer has a thickness greater than the preferred thickness, problems such as excessive local film stress, excessive use of film materials, poor appearance, and increased equipment failure rate, are likely to occur. The refractive index difference between the two layers of materials is preferably 0.5-0.8, and the refractive index difference not only ensures a sufficient refractive index difference and achieves an excellent spectral regulation effect with fewer layers, but also helps to select more suitable materials for product processing; and further, under this film thickness setting, a lower refractive index difference leads to a low near-infrared reflectance, thereby affecting the cooling effect of radiative cooling.

The optical regulation layer is provided with a plurality of layers of the low refractive index material and a plurality of layers of the high refractive index material, the total number of layers is preferably 38-50, fewer layers result in failure to coordinate optical effects of various bands, and more layers result in poor binding strength between the optical regulation layer and the substrate and reduce light transmittance. Each low refractive index material and each high refractive index material are metal oxides or non-metal oxides, and each low refractive index material and each high refractive index material have a transmittance of higher than 90% in a visible light band within a nanometer thickness range. Each low refractive index material may be identical or different, and is preferably selected from one or more of titanium oxide [TiO₂], titanium pentoxide [Ti₃O₅], zirconium oxide [ZrO₂], cesium oxide [CeO₂], hafnium oxide [HfO₂], niobium pentoxide [Nb₂O₅], and tantalum pentoxide [Ta₂O₅]; and each high refractive index material may be identical or different, and is preferably selected from one or more of silicon dioxide [SiO₂], silicon monoxide [SiO], magnesium fluoride [MgF₂], aluminum oxide [Al₂O₃], a silicon-aluminum mixture [PR0₄], a silicon-aluminum mixture [PR0₆], cryolite, and aluminum fluoride [AlF₃], where the above high refractive index materials absorb no light in a spectral band to be regulated, which is beneficial to enhancing the optical regulation effect.

The thickness setting of the high refractive index material and the low refractive index material affects the optical regulation effect of material layers; in the present disclosure, a preferred thickness of the high refractive index material is 10-200 nm, and a preferred thickness of the low refractive index material is 20-300 nm; the thickness combination not only ensures the uniformity of the material layers, but also prevents excessive film stress, and reduces the possibility of film cracking; and furthermore, the thickness combination enables to keenly distinguish light beams of various bands, regulate paths of light beams of various bands, effectively distinguish visible light, near-infrared light, and mid-infrared light, increase the transmittance in a visible light band based on light interference, and enhance the reflectance in a near-infrared band.

The alternate lamination of the high refractive index material and the low refractive index material in the present disclosure is not limited to the adjacent alternate lamination, but the lamination method of a plurality of layers of the low refractive index material-the high refractive index material-the low refractive index material may be adopted, that is, the lamination methods may include: (1) one layer of the high refractive index material-one layer of the low refractive index material-one layer of the high refractive index material...; and (2) two layers of the high refractive index material-one layer of the low refractive index material-one layer of the high refractive index material-two layers of the low refractive index material.... The lamination method (2) enables to enhance the regulatability of bands, such that light of different bands presents different optical properties.

The optical regulation layer in the present disclosure may be directly deposited on the substrate, or a transition layer may be first deposited on the substrate, where the presence of the transition layer is beneficial to enhancing bonding stability between the optical regulation layer and the substrate; the transition layer is preferably an organic material, which is hereinafter referred to as a first organic layer, more preferably SA, RA, SHA, a phthalocyanine-based organic compound, or the like, where SA, RA, and SHA are organic material products with models SA, RA, and SHA produced by Nano Primer, ceko, South Korea; and when SA, RA, SHA, or the phthalocyanine-based organic compound serves as the first organic layer, no light is absorbed in a visible light band, which reduces the impact of a film layer on the transmittance in the visible light band, has excellent impact resistance, and enhances the bonding stability between the substrate and the optical regulation layer. A second organic layer is disposed above the optical regulation layer, i.e., on a side of the optical regulation layer facing away from the substrate, and the second organic layer is a hydrophobic and oleophobic organic compound, preferably a fluorine-containing organic compound, more preferably an anti-fingerprint (AF) film, where AF has extremely low surface energy and achieves the surface self-cleaning function. The arrangement of the second organic layer, on one hand, ensures that the film material of the present disclosure is not easily contaminated by water or oil stains during use, but achieves the self-cleaning function; and on the other hand, AF has excellent spectral regulation performance. A thickness of an AF layer is preferably (10-40) nm, and when the thickness of AF is less than 10 nm, it is difficult to form a dense film layer on a surface thereof, thereby resulting in poor hydrophobic effect. When the thickness exceeds 40 nm, a layer of oil stain is formed on the surface, which cannot be effectively combined with any other film layer, and an excessive thickness of the film layer causes material waste and surface blooming.

The second organic layer needs to be deposited into a film by a resistive evaporation process, current is preferably (30-200) mA, a coating rate is (3-9) A/s, and a too low evaporation rate results in insufficient kinetic energy of the AF material, a low film thickness, and poor film density. A too high evaporation rate results in poor product uniformity.

As a preferred solution, the second organic layer is disposed on the substrate, specifically disposed on a side of the substrate facing away from the optical regulation layer, and when the film is pasted, the optical regulation layer is in contact with a display screen through AB glue, and the second organic layer is placed on a surface thereof. This arrangement enhances the hydrophobic performance and wear resistance of the AF material.

As a preferred solution, in the present disclosure, the high refractive index material is TiO₂, the low refractive index material is SiO2, the optical regulation layer is formed by alternate lamination of TiO₂ and SiO2, with a total of 41 layers, the first organic layer is SHA, the second organic layer is AF, and particle sizes of the high refractive index material and the low refractive index material are both (1-3) mm. A production process is as follows:

A coating temperature of the optical regulation layer is 100°C, and a vacuum degree is set to 1*10⁻³ Pa. Energy of SiO₂ ion source-assisted plating is 170V and 6A; energy of TiO₂ ion source-assisted plating is 200V and 8A; SHA is processed by electron beam (EB) evaporation with a current of 10-60 mA; and AF is processed by a resistive evaporation process with a heating current of 100-200 mA.

| Material layer | Material | Thickness (nm) | Coating rate (A/s) |
|---|---|---|---|
| Low refractive index material | SiO2 | 15-300 | 4-6 |
| High refractive index material | TiO₂ | 10-200 | 2-2.5 |
| First organic layer | SHA | 80-150 | 3-8 |
| Second organic layer | AF | 30 nm | 4-10 |

As a preferred solution, in the present disclosure, the high refractive index material is TiO₂ (n=2.35@500 nm), the low refractive index material is SiO₂ (n=1.46@550 nm)& MgF₂(n=1.38@550 nm),

A coating temperature is 150°C, and a vacuum degree is set to 1.5*10⁻³. Energy of SiO₂ ion source-assisted plating is 200V and 7A; energy of TiO₂ ion source-assisted plating is 250V and 7.5A; SHA is processed by EB evaporation with a current of 10-60 mA; and AF is processed by a resistive evaporation process with a heating current of 100-200 mA.

| Material layer | Material | Thickness (nm) | Coating rate (A/s) |
|---|---|---|---|
| Low refractive index material | SiO₂&MgF₂ | 15-300 | 4-6 |
| High refractive index material | TiO₂ | 10-200 | 2-2.5 |
| First organic layer | SHA | 80-150 | 3-8 |
| Second organic layer | AF | 30 nm | 4-10 |

As a preferred solution, in the present disclosure, the high refractive index material is Ta₂O₅ (n=2.32@500 nm), the low refractive index material is SiO₂ (n=1.46@550 nm), the total number of layers of the high refractive index material and the low refractive index material is 49, particle sizes of the high refractive index material and the low refractive index material are both 1-3 mm, the first organic layer is SA, the second organic layer is AF, and a preparation process adopted is as follows:

A coating temperature is 100°C, and a vacuum degree is set to 1*10⁻³. Energy of SiO₂ ion source-assisted plating is 170V and 6A; energy of Ta₂O₅ ion source-assisted plating is 200V and 8A; SA is processed by EB evaporation with a current of 10-60 mA; and AF is processed by a resistive evaporation process with a heating current of 100-200 mA.

| Material layer | Material | Thickness (nm) | Coating rate (A/s) |
|---|---|---|---|
| Low refractive index material | SiO₂ | 15-300 | 4-6 |
| High refractive index material | Ta₂O₅ | 10-200 | 2-2.5 |
| First organic layer | SA | 80-150 | 3-8 |
| Second organic layer | AF | 30 nm | 4-10 |

The beneficial effects of the present disclosure include: through the structural design of a multilayer film, the film is used to regulate the spectral performance in different bands, and the film material of the present disclosure has the following properties: (1) high near-infrared blocking performance; (2) no impact on sensor sensing effect; (3) effective isolation of other energy incident from a solar light band; (4) emission of heat in the form of electromagnetic waves to a natural cold source of the universe through a thermal infrared band, to achieve the maximum radiative cooling effect.

Through the alternate lamination of the high refractive index material and the low refractive index material (the film material), the light interference effect, and stacking of different materials, the present disclosure increases the transmittance in a visible light band, the reflectance in a near-infrared band, and the emissivity in a mid-infrared band. Finally, the present disclosure achieves a visible light transmittance of over 90%, a maximum near-infrared blocking rate of over 80%, a mid-infrared band emissivity of over 90%, a high transmittance of over 90% in the 940-1000 nm band, and a cooling effect of 3-8 degrees Celsius.

The film material of the present disclosure may be attached to a surface of almost any material for cooling, such as glass, a wall, a roof, or a display device of electronic equipment, and is an effective tool for energy conservation and emission reduction. Adding an organic encapsulation layer on a surface of the film material enables the product to have excellent anti-aging characteristics, such that the film material has excellent hydrophobic, antifouling, and wear-resistant performance during use.

When the film material of the present disclosure is applied to display devices, flat-panel display devices, especially products represented by mobile phones, have a large number of sensors integrated on their screens, such as fingerprint sensors, Face ID sensors, distance sensors, ambient light sensors, TOF sensors, or the like. Operating wavelengths of these sensors are mainly concentrated in a visible light or near-infrared band (commonly including 940 nm). The film material of the present disclosure achieves a high transmittance of waves at 940 nm, and ensures sensor sensitivity.

According to Planck's law of thermal radiation: B (λ, T)=(2hc²/λ⁵)*(1/(e^(hc/λkT)-1)), where B (λ, T) is a radiant energy density per unit area and per unit wavelength, λ is a wavelength, T is an absolute temperature, c is a speed of light, h is a Planck's constant, and k is a Boltzmann's constant. Operating temperatures of products related to daily life are 30-70°C, especially display devices usually operate at a temperature of 30-60°C, and a main wavelength range of thermal radiation is located in an atmospheric window region. The present disclosure is attached to screen cover glass of a display device, and broad-spectrum regulation is performed to achieve isolation of solar radiation and thermal radiation, optimize an operating wavelength of optical sensors to ensure normal operation, and improve a thermal radiation capacity of the product in an 8-13 µm atmospheric window band.

### BRIEF DESCRIPTION OF THE DRAWINGS

FIG. 1 is a structural diagram of a film material in Example 1.
FIG. 2 illustrates transmittances of a film before and after coating in Example 1.
FIG. 3 illustrates emissivities of the film material in Example 1.
FIG. 4 illustrates detection values of a display with a film, a display without a film, and ambient temperatures.
FIG. 5 is a structural diagram of a film material in Example 2.

### DETAILED DESCRIPTIONS OF THE EXAMPLES

The present disclosure will be further explained and described in detail below with reference to the accompanying drawings and specific examples, but it should be understood that the protection scope of the present disclosure is not limited by the specific examples.

### Example 1

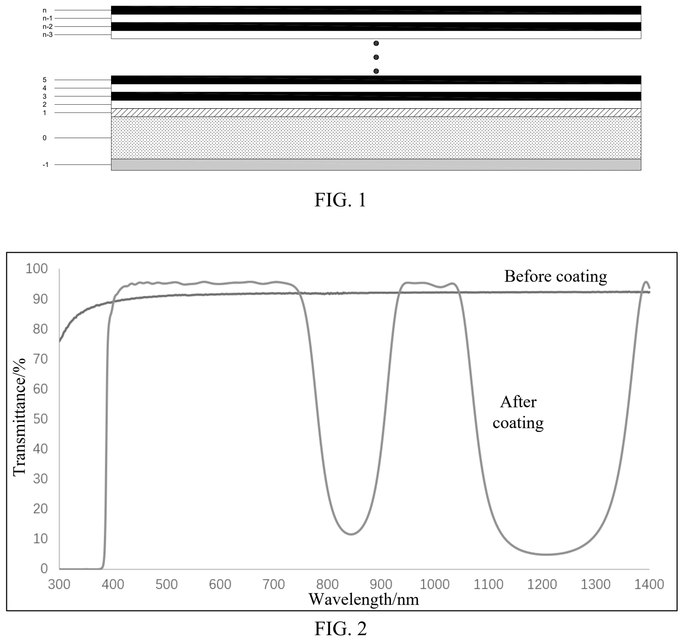

A substrate of a film material in this example is a commercial tempered glass film of mobile phone, a high refractive index material in an optical regulation layer is TiO₂ (n=2.35@500 nm), a low refractive index material is SiO₂ (n=1.46@550 nm),the optical regulation layer is obtained through an electron beam evaporation coating system, with a total of 39 layers sequentially arranged from near the substrate to away from the substrate: TiO₂ layer, SiO₂ layer, TiO₂ layer...SiO₂ layer, and TiO₂ layer, where a thickness and coating rate of each layer are shown in Table 1, and particle sizes of the high refractive index material and the low refractive index material are 1-3 mm. SHA & AF are employed for an organic layer. A structure of the film material is shown in FIG. 1, a first organic layer is deposited on the substrate, and a second organic layer is deposited on a back side of the substrate, where labels 1/2/3...n in the figure represent a layer number of the optical regulation layer.

A coating temperature of the optical regulation layer is 100°C, and a vacuum degree is set to 1*10⁻³. Energy of SiO₂ ion source-assisted plating is 170V and 6A; energy of TiO₂ ion source-assisted plating is 200V and 8A; SHA is processed by electron beam (EB) evaporation with a current of 10-60 mA; and AF is processed by a resistive evaporation process with a heating current of 100-200 mA.

**Table 1 Material, thickness, and coating rate of each layer**

| Layer No. | Material | Thickness (nm) | Rate (A/s) |
|---|---|---|---|
| 1 | SHA | 100 | 8 |
| 2 | TIO2 | 14.47 | 2.5 |
| 3 | SIO2 | 28.57 | 6 |
| 4 | TIO2 | 114.7 | 2.5 |
| 5 | SIO2 | 36.54 | 6 |
| 6 | TIO2 | 13 | 2.5 |
| 7 | SIO2 | 99.42 | 6 |
| 8 | TIO2 | 16.98 | 2.5 |
| 9 | SIO2 | 30.36 | 6 |
| 10 | TIO2 | 144.72 | 2.5 |
| 11 | SIO2 | 25 | 6 |
| 12 | TIO2 | 26.29 | 2.5 |
| 13 | SIO2 | 192.99 | 6 |
| 14 | TIO2 | 108.41 | 2.5 |
| 15 | SIO2 | 184.96 | 6 |
| 16 | TIO2 | 38.51 | 2.5 |
| 17 | SIO2 | 28.88 | 6 |
| 18 | TIO2 | 27.35 | 2.5 |
| 19 | SIO2 | 373.2 | 6 |
| 20 | TIO2 | 25.28 | 2.5 |
| 21 | SIO2 | 33.09 | 6 |
| 22 | TIO2 | 35.37 | 2.5 |
| 23 | SIO2 | 186.66 | 6 |
| 24 | TIO2 | 109.58 | 2.5 |
| 25 | SIO2 | 194.07 | 6 |
| 26 | TIO2 | 26.55 | 2.5 |
| 27 | SIO2 | 25 | 6 |
| 28 | TIO2 | 148.09 | 2.5 |
| 29 | SIO2 | 32.22 | 6 |
| 30 | TIO2 | 17.21 | 2.5 |
| 31 | SIO2 | 112.23 | 6 |
| 32 | TIO2 | 14.17 | 2.5 |
| 33 | SIO2 | 37.89 | 6 |
| 34 | TIO2 | 137.03 | 2.5 |
| ·35 | SIO2 | 25 | 6 |
| 36 | TIO2 | 35.18 | 2.5 |
| 37 (n-3) | SIO2 | 40.65 | 6 |
| 38 (n-2) | TIO2 | 27.6 | 2.5 |
| 39 (n-1) | SIO2 | 50.02 | 6 |
| 40 (n) | TIO2 | 13 | 2.5 |
| -1 | AF | 20 | 6 |

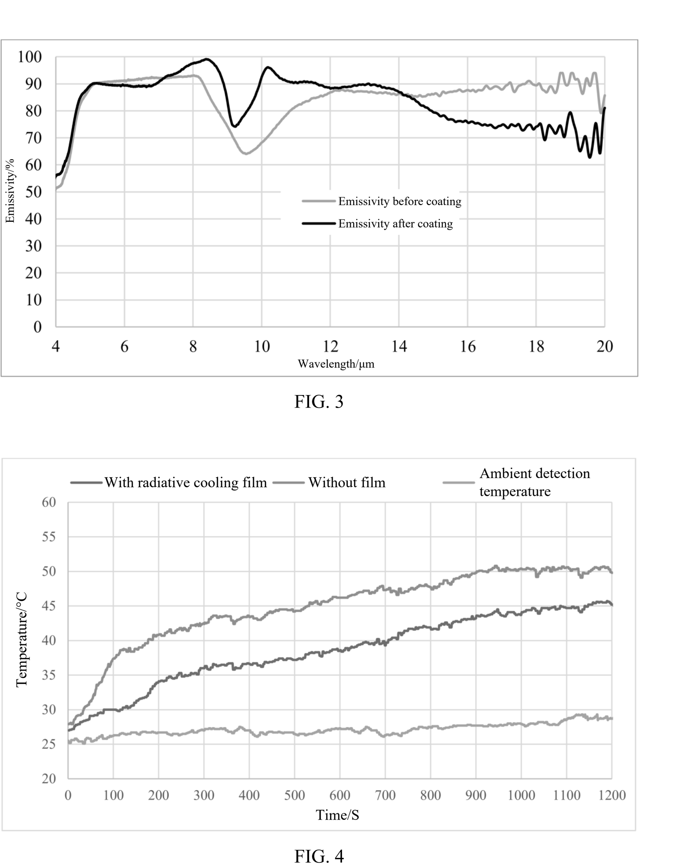

Original glass (a commercial tempered glass film of mobile phone) and coated glass were tested respectively.
1. Reflectances of commercial glass and coated glass in a solar light band were tested by using a UV-vis-nir spectrophotometer (uv3600, Shimadzu) equipped with an integrating sphere module (ISR-3100), with a test range of (0.3-2.5) µm.
   The reflectances of the glass before and after coating are shown in FIG. 2, and the results show that after adding a radiative cooling film of the present disclosure, the transmittance of the glass in a near-infrared band significantly reduced from 90% of the original glass to about 30%,.
2. The emissivities of the commercial glass and the coated glass in a mid-infrared band were tested by using a Fourier transform infrared (FT-IR) spectrometer (Nicolet IS50, ThermoFisher), a gold integrating sphere (IntergatIR MIR, Pike), and a mercury cadmium telluride detector. The emissivities of the glass before and after coating are shown in FIG. 3, and the results show that after adding the radiative cooling film of the present disclosure, the emissivity of the glass in mid- to far-infrared bands was significantly improved, especially in an atmospheric window (8-13 µm), from an average of less than 0.8 of the original glass to more than 0.9.
3. The cooling effect of the commercial glass and the coated glass was tested, a temperature tester was placed on the coated glass and the original glass (attached to a commercial mobile phone in operation with a screen always on) and in the air respectively, and temperature changes under the three conditions were recorded simultaneously, where a lower temperature indicated a better cooling effect, and an instrument used was a K-type Omega thermocouple. The results shown in FIG. 4 indicate that under outdoor conditions with an ambient temperature of about 30°C, the coated glass reduces an operating temperature of a mobile phone by 3-8°C, demonstrating a significant cooling effect.
4. The hydrophobic performance of the coated glass was tested by using a Theta contact angle tester (LSA100, LAUDA Scientific), and an average static contact angle measured exceeded 115°, indicating excellent hydrophobic performance.

### Example 2

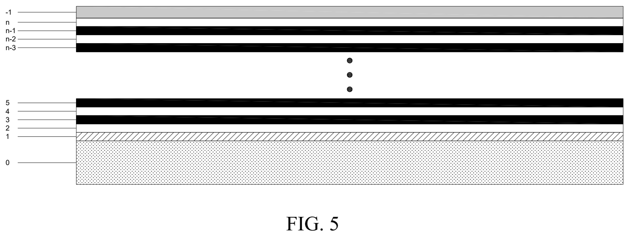

A substrate of a film material in this example is tempered glass, a low refractive index material in an optical regulation layer is SiO₂, a high refractive index material is TiO₂, the optical regulation layer is obtained through an electron beam evaporation coating system, with a total of 36 layers, and particle sizes of the high refractive index material and the low refractive index material are 1-3 mm. SHA & AF are employed for an organic layer, a structure after coating is shown in FIG. 5, a first organic layer is deposited between the optical regulation layer and the glass substrate as a buffer transition layer, and a second organic layer is deposited on the optical regulation layer.

A coating temperature is 150°C, and a vacuum degree is set to 1.5*10⁻³. Energy of SiO₂ ion source-assisted plating is 200V and 7A; energy of TiO₂ ion source-assisted plating is 250V and 7.5A; SHA is processed by EB evaporation with a current of 10-60 mA; and AF is processed by a resistive evaporation process with a heating current of 100-200 mA.

**Table 2 Material, thickness, and coating rate of each layer**

| Layer No. | Material | Thickness (nm) | Rate (A/s) |
|---|---|---|---|
| 1 | SHA | 100 | 8 |
| 2 | TIO2 | 14.08 | 2.5 |
| 3 | SIO2 | 27.38 | 6 |
| 4 | TIO2 | 112.05 | 2.5 |
| 5 | SIO2 | 31.6 | 6 |
| 6 | TIO2 | 17.57 | 2.5 |
| 7 | SIO2 | 75.99 | 6 |
| 8 | TIO2 | 18.9 | 2.5 |
| 9 | SIO2 | 32.78 | 6 |
| 10 | TIO2 | 141.74 | 2.5 |
| 11 | SIO2 | 27 | 6 |
| 12 | TIO2 | 25.11 | 2.5 |
| 13 | SIO2 | 194.84 | 6 |
| 14 | TIO2 | 109.22 | 2.5 |
| 15 | SIO2 | 175.86 | 6 |
| 16 | TIO2 | 117.77 | 2.5 |
| 17 | SIO2 | 46.39 | 6 |
| 18 | TIO2 | 12 | 2.5 |
| 19 | SIO2 | 263.95 | 6 |
| 20 | TIO2 | 25.19 | 2.5 |
| 21 | SIO2 | 32.87 | 6 |
| 22 | TIO2 | 35.99 | 2.5 |
| 23 | SIO2 | 188.33 | 6 |
| 24 | TIO2 | 110.48 | 2.5 |
| 25 | SIO2 | 194.35 | 6 |
| 26 | TIO2 | 25.65 | 2.5 |
| 27 | SIO2 | 27 | 6 |
| 28 | TIO2 | 151.49 | 2.5 |
| 29 | SIO2 | 27 | 6 |
| 30 | TIO2 | 21.93 | 2.5 |
| 31 | SIO2 | 233.95 | 6 |
| 32 | TIO2 | 14.75 | 2.5 |
| 33 | SIO2 | 63.54 | 6 |
| 34 (n-3) | TIO2 | 27.16 | 2.5 |
| 35 (n-2) | SIO2 | 31.28 | 6 |
| 36 (n-1) | TIO2 | 123.53 | 2.5 |
| 37 (n) | SIO2 | 91.58 | 6 |
| -1 | AF | 20 | 6 |
| | | | |

Original glass (a commercial tempered glass film of mobile phone) and coated glass were tested respectively.
1. Reflectances of commercial glass and coated glass in a solar light band were tested by using a UV-vis-nir spectrophotometer (uv3600, Shimadzu) equipped with an integrating sphere module (ISR-3100), with a test range of (0.3-2.5) µm.
   The reflectances of the glass before and after coating show that after adding a radiative cooling film of the present disclosure, the transmittance of the glass in a near-infrared band significantly reduced from 90% of the original glass to about 30%,.
2. The emissivities of the commercial glass and the coated glass in a mid-infrared band were tested by using a Fourier transform infrared (FT-IR) spectrometer (Nicolet IS50, ThermoFisher), a gold integrating sphere (IntergatIR MIR, Pike), and a mercury cadmium telluride detector. The emissivities of the glass before and after coating show that after adding the radiative cooling film of the present disclosure, the emissivity of the glass in mid- to far-infrared bands was significantly improved, especially in an atmospheric window (8-13 µm), from an average of less than 0.8 of the original glass to more than 0.9.
3. A reflectance of a processed product attached to a screen with adhesive was tested by using a colorimeter (HC-CR8W), and a tested reflectance Y was about 1.8. A reflectance of the original glass attached to a screen with adhesive was tested, and a tested reflectance Y was about 5.3. The processed product has obvious anti-reflection and anti-glare functions.
4. The cooling effect of the commercial glass and the coated glass was tested, a temperature tester was placed on the coated glass and the original glass (attached to a commercial mobile phone in operation with a screen always on) and in the air respectively, and temperature changes under the three conditions were recorded simultaneously, where a lower temperature indicated a better cooling effect, and an instrument used was a K-type Omega thermocouple. Under outdoor conditions with an ambient temperature of about 30°C, the coated glass reduces an operating temperature of a mobile phone by 3-8°C, demonstrating a significant cooling effect.
4. The hydrophobic performance of the coated glass was tested by using a Theta contact angle tester (LSA100, LAUDA Scientific), and an average static contact angle measured exceeded 115°, indicating excellent hydrophobic performance.

### Example 3

A substrate of a film material in this example is tempered glass, a low refractive index material in an optical regulation layer is SiO₂, a high refractive index material is Ta₂O₅ (n=2.32@500 nm), the optical regulation layer is obtained through an electron beam evaporation coating system, with a total of 39 layers sequentially arranged from near the substrate to away from the substrate:TA2O5 layer, SIO2 layer, TA2O5 layer, SIO2 layer...TA2O5 layer, and SIO2 layer, and particle sizes of the high refractive index material and the low refractive index material are 1-3 mm. A first organic layer is SA, a second organic layer is AF (a granular material), the first organic layer is disposed between the optical regulation layer and the substrate material, and the second organic layer is disposed on a side of the optical regulation layer facing away from the first organic layer.

A coating temperature is 100°C, and a vacuum degree is set to 1*10⁻³. Energy of SiO₂ ion source-assisted plating is 170V and 6A; energy of Ta₂O₅ ion source-assisted plating is 200V and 8A; SA is processed by EB evaporation with a current of 10-60 mA; and AF is processed by a resistive evaporation process with a heating current of 100-200 mA.

**Table 3 Material, thickness, and coating rate of each layer**

| Layer No. | Material | Thickness (nm) | Rate (A/s) |
|---|---|---|---|
| 1 | SA | 100 | 8 |
| 2 | TA2O5 | 15.81 | 2.5 |
| 3 | SIO2 | 28.57 | 6 |
| 4 | TA2O5 | 125.35 | 2.5 |
| 5 | SIO2 | 36.54 | 6 |
| 6 | TA2O5 | 14.21 | 2.5 |
| 7 | SIO2 | 99.42 | 6 |
| 8 | TA2O5 | 18.56 | 2.5 |
| 9 | SIO2 | 30.36 | 6 |
| 10 | TA2O5 | 158.15 | 2.5 |
| 11 | SIO2 | 25 | 6 |
| 12 | TA2O5 | 28.74 | 2.5 |
| 13 | SIO2 | 192.99 | 6 |
| 14 | TA2O5 | 118.47 | 2.5 |
| 15 | SIO2 | 184.96 | 6 |
| 16 | TA2O5 | 42.08 | 2.5 |
| 17 | SIO2 | 28.88 | 6 |
| 18 | TA2O5 | 29.89 | 2.5 |
| 19 | SIO2 | 373.2 | 6 |
| 20 | TA2O5 | 27.63 | 2.5 |
| 21 | SIO2 | 33.09 | 6 |
| 22 | TA2O5 | 38.65 | 2.5 |
| 23 | SIO2 | 186.66 | 6 |
| 24 | TA2O5 | 119.76 | 2.5 |
| 25 | SIO2 | 194.07 | 6 |
| 26 | TA2O5 | 29.02 | 2.5 |
| 27 | SIO2 | 25 | 6 |
| 28 | TA2O5 | 161.84 | 2.5 |
| 29 | SIO2 | 32.22 | 6 |
| 30 | TA2O5 | 18.81 | 2.5 |
| 31 | SIO2 | 112.23 | 6 |
| 32 | TA2O5 | 15.49 | 2.5 |
| 33 | SIO2 | 37.89 | 6 |
| 34 | TA2O5 | 149.76 | 2.5 |
| 35 | SIO2 | 25 | 6 |
| 36 | TA2O5 | 38.44 | 2.5 |
| 37 (n-3) | SIO2 | 40.65 | 6 |
| 38 (n-2) | TA2O5 | 30.17 | 2.5 |
| 39 (n-)1 | SIO2 | 50.02 | 6 |
| 40 (n) | TA2O5 | 14.21 | 2.5 |
| -1 | AF | 20 | 6 |

Original glass (a commercial tempered glass film of mobile phone) and coated glass were tested respectively.
1. Reflectances of commercial glass and coated glass in a solar light band were tested by using a UV-vis-nir spectrophotometer (uv3600, Shimadzu) equipped with an integrating sphere module (ISR-3100), with a test range of (0.3-2.5) µm.
   The reflectances of the glass before and after coating show that after adding a radiative cooling film of the present disclosure, the transmittance of the glass in a near-infrared band significantly reduced from 90% of the original glass to about 40%,.
2. The emissivities of the commercial glass and the coated glass in a mid-infrared band were tested by using a Fourier transform infrared (FT-IR) spectrometer (Nicolet IS50, ThermoFisher), a gold integrating sphere (IntergatIR MIR, Pike), and a mercury cadmium telluride detector. The emissivities of the glass before and after coating show that after adding the radiative cooling film of the present disclosure, the emissivity of the glass in mid- to far-infrared bands was significantly improved, especially in an atmospheric window (8-13 µm), from an average of less than 0.8 of the original glass to more than 0.9.
3. The cooling effect of the commercial glass and the coated glass was tested, a temperature tester was placed on the coated glass and the original glass (attached to a commercial mobile phone in operation with a screen always on) and in the air respectively, and temperature changes under the three conditions were recorded simultaneously, where a lower temperature indicated a better cooling effect, and an instrument used was a K-type Omega thermocouple. Under outdoor conditions with an ambient temperature of about 30°C, the coated glass reduces an operating temperature of a mobile phone by 3-6°C, demonstrating an obvious cooling effect.
4. The hydrophobic performance of the coated glass was tested by using a Theta contact angle tester (LSA100, LAUDA Scientific), and an average static contact angle measured exceeded 115°, indicating excellent hydrophobic performance.

The above examples are merely intended for describing the technical solutions of the present disclosure rather than limiting same. Although the present disclosure is described in detail with reference to the above examples, persons of ordinary skill in the art should understand that they may still make modifications or equivalent replacements to the technical solutions of the present disclosure without departing from the spirit and scope of the technical solutions of the present disclosure.

## Claims

1. A display film material, comprising a substrate and an optical regulation layer disposed on the substrate, wherein the substrate has an absorptance of less than 5% and a transmittance of greater than 80% in a 400-780 nm band, and an absorptance of less than 5% in a 900-1400 nm band, and the optical regulation layer is formed by alternate lamination of a low refractive index material and a high refractive index material, wherein a refractive index difference between the low refractive index material and the high refractive index material is greater than 0.5, and after light passes through the optical regulation layer and the substrate, a transmittance in the 400-780 nm band is greater than 80%, an emissivity in a 8-13 µm band is greater than 85%, a reflectance in the 900-1400 nm band is greater than 70%, and a transmittance in the 940-1000 nm band is greater than 80%.

2. The display film material according to claim 1, wherein the numbers of layers of the high refractive index material and the low refractive index material are identical or different, the total number of layers of the spectral regulation layer is 28-50, components of each layer of the low refractive index material are identical or different, with identical or different thicknesses; components of each layer of the high refractive index material are identical or different, with identical or different thicknesses; and
the optical regulation layer is directly or indirectly disposed on the substrate.

3. The display film material according to claim 2, wherein the optical regulation layer is disposed on the substrate through a first organic layer, a light absorptance of the first organic layer in the 400-780 nm band is less than 5%, and the first organic layer is selected from one or more of SA, RA, SHA, and a phthalocyanine-based organic compound.

4. The display film material according to claim 1, wherein the spectral regulation layer satisfies at least one or more of the following combinations
- the high refractive index material is selected from one or more of TiO₂, Ti₃O₅, ZrO₂, CeO₂, HfO₂, Nb₂O₅, and Ta₂O₅;
- the low refractive index material is selected from one or more of SiO₂, SiO, MgF₂, AL₂O₃, PRO₄, PRO₆, cryolite, and AlF₃;
- the low refractive index material has a thickness of 20-300 nm; and
- the high refractive index material has a thickness of 10-200 nm.

5. The display film material according to claim 1, wherein a second organic layer is disposed on a side of the substrate facing away from the optical regulation layer, or a second organic layer is disposed on a side of the optical regulation layer facing away from the substrate, and the second organic layer satisfies at least one or more of the following combinations:
- the second organic layer is a fluorine-containing organic compound;
- the second organic layer is AF;
- a water contact angle of the second organic layer is greater than 115°;
- the second organic layer has a thickness of 10-40 nm; and
- the second organic layer is deposited by a resistive evaporation process, a preferred range of resistive evaporation current is (30-200) mA, and a coating rate is (3-9) A/s.

6. The display film material according to claim 1, wherein a first organic layer and a second organic layer are respectively disposed on both sides of the substrate, the optical regulation layer is disposed on a side where the first organic layer is disposed, the optical regulation layer is formed by alternate lamination of TiO₂ and SiO₂,with a total of 41-49 layers, a TiO₂ layer has a thickness of (15-300) nm, and a SiO₂ layer has a thickness of (10-200) nm; and the first organic layer is SHA, and the second organic layer is AF.

7. The display film material according to claim 1, wherein in a thickness direction of the optical regulation layer, at least two layers of materials with a refractive index difference of 0.5-0.8 are arranged in any thickness interval of 25 nm-500 nm.

8. The display film material according to claim 1, wherein after light passes through the optical regulation layer and the substrate, a transmittance in a visible light band is greater than 90%, an emissivity in a mid-infrared band is greater than 95%, a reflectance in a near-infrared band is greater than 80%, and a transmittance at 940 nm is greater than 90%.

9. The display film material according to claim 1, wherein materials and thicknesses of each layer in the spectral regulation layer are as follows:
| Layer No. | Material | Thickness (nm) |
|---|---|---|
| 1 | TIO2 | 14.47 |
| 2 | SIO2 | 28.57 |
| 3 | TIO2 | 114.7 |
| 4 | SIO2 | 36.54 |
| 5 | TIO2 | 13 |
| 6 | SIO2 | 99.42 |
| 7 | TIO2 | 16.98 |
| 8 | SIO2 | 30.36 |
| 9 | TIO2 | 144.72 |
| 10 | SIO2 | 25 |
| 11 | TIO2 | 26.29 |
| 12 | SIO2 | 192.99 |
| 13 | TIO2 | 108.41 |
| 14 | SIO2 | 184.96 |
| 15 | TIO2 | 38.51 |
| 16 | SIO2 | 28.88 |
| 17 | TIO2 | 27.35 |
| 18 | SIO2 | 373.2 |
| 19 | TIO2 | 25.28 |
| 20 | SIO2 | 33.09 |
| 21 | TIO2 | 35.37 |
| 22 | SIO2 | 186.66 |
| 23 | TIO2 | 109.58 |
| 24 | SIO2 | 194.07 |
| 25 | TIO2 | 26.55 |
| 26 | SIO2 | 25 |
| 27 | TIO2 | 148.09 |
| 28 | SIO2 | 32.22 |
| 29 | TIO2 | 17.21 |
| 30 | SIO2 | 112.23 |
| 31 | TIO2 | 14.17 |
| 32 | SIO2 | 37.89 |
| 33 | TIO2 | 137.03 |
| 34 | SIO2 | 25 |
| 35 | TIO2 | 35.18 |
| 36 | SIO2 | 40.65 |
| 37 | TIO2 | 27.6 |
| 38 | SIO2 | 50.02 |
| 39 | TIO2 | 13 |

10. A preparation method for the display film material according to claim 1, wherein TiO₂ serves as a high refractive index material, SiO₂ serves as a low refractive index material, both TiO₂ and SiO₂ are formed by electron beam evaporation coating and deposition, a coating temperature is (100-150) °C, a vacuum degree is set to 1*10⁻³-1.5*10⁻³, energy of SiO₂ ion source-assisted coating is(170-200) V and(6-7) A, and energy of TiO₂ ion source-assisted coating is (200-250) V and (7.5-8) A; a particle size of TiO₂ is 1-3 mm; and a particle size of SiO₂ material is 1-3 mm.
